**Europäisches Patentamt**

**European Patent Office**

**Office européen des brevets**

(19)

(11) Numéro de publication : **0 583 191 A1**

(12) # DEMANDE DE BREVET EUROPEEN

(21) Numéro de dépôt : **93401971.2**

(22) Date de dépôt : **29.07.93**

(51) Int. Cl.⁵ : **H01S 3/00,** H01L 31/12, G01S 17/02

(30) Priorité : **31.07.92 FR 9209530**

(43) Date de publication de la demande : **16.02.94 Bulletin 94/07**

(84) Etats contractants désignés : **AT BE CH DE DK ES GB IT LI NL SE**

(71) Demandeur : **Chebbi, Brahim 24 Rue Marie Debos F-92120 Montrouge (FR)**

(72) Inventeur : **Chebbi, Brahim 24 Rue Marie Debos F-92120 Montrouge (FR)**

(74) Mandataire : **Hirsch, Marc-Roger et al Cabinet Hirsch 34 rue de Bassano F-75008 Paris (FR)**

(54) **Laser à semiconducteur utilisé comme détecteur photosensible, et son application dans un système de détection optique.**

(57)     L'invention concerne un laser à semi-conducteur 1 dont au moins l'une des faces miroir 5 a subi un traitement anti-reflet pour permettre la détection d'un rayonnement lumineux de longueur d'onde comprise dans le spectre d'émission du laser.

    Elle a aussi pour objet un procédé pour l'obtention d'un détecteur photosensible, consistant à traiter une ou plusieurs faces miroir d'un laser à semi-conducteur par un traitement anti-reflet.

    Elle concerne enfin l'application d'un laser à semi-conducteur ayant subi un traitement anti-reflet sur au moins l'une de ses faces miroir à la détection d'un rayonnement lumineux. Avantageusement, l'invention s'applique à la réalisation de barrières opto-électroniques, de systèmes de mesure optique sans contact, ou de systèmes de lecture.

FIG.2

EP 0 583 191 A1

La présente invention a pour objet un laser à semi-conducteur pour la détection d'un rayonnement lumineux de longueur d'onde comprise dans la bande d'émission du laser.

Elle concerne aussi un procédé d'obtention d'un détecteur photosensible. Enfin, elle se rapporte à l'application d'un laser à semi-conducteur à la détection d'un rayonnement lumineux de longueur d'onde comprise dans le spectre d'émission du laser.

Elle est susceptible d'applications en particulier, dans les domaines des dispositifs de protection à rayonnement du type barrières opto-électroniques, dans les systèmes de mesure optique sans contact ou dans les systèmes de lecture optique.

Un laser à semi-conducteur est un dispositif à semi-conducteur qui, lorsqu'il est excité par un signal électrique, émet un rayonnement lumineux cohérent. Les caractéristiques de ce rayonnement lumineux dépendent des constituants du laser ainsi que du signal électrique qui l'excite.

Un laser à semi-conducteur est généralement constitué d'une couche agissant comme guide d'onde disposée entre la couche P et la couche N d'une jonction P-N. Cette couche agissant comme guide d'onde présente une forme rectangulaire. L'émission par le laser à semi-conducteur du rayonnement lumineux se fait sur des faces opposées du guide d'onde, qui sont appelées faces miroir. Les faces miroir sont obtenues par clivage et forment pour le rayonnement des miroirs semi-réfléchissants. La combinaison de ces deux faces miroir constitue un laser de type Fabry-Pérot. Dans certains lasers, une des faces miroir subit un traitement la rendant réfléchissante, et l'émission du rayonnement ne se fait que sur l'autre face.

Les lasers à semi-conducteurs sont utilisés comme source de rayonnement dans de nombreuses applications, et par exemple dans la transmission par fibre optique, dans les barrières photoélectriques ou dans les systèmes de lecture par laser.

Les systèmes optiques qui utilisent un laser à semi-conducteur comme source lumineuse comprennent en outre un détecteur, susceptible de détecter le rayonnement émis par le laser. Ce détecteur peut être constitué d'une photodiode, ou de tout autre type de composant sensible au rayonnement émis par le laser, tel que détecteurs photovoltaïques, photomultiplicateurs, etc. Ces systèmes optiques présentent donc au moins deux types de composants, présentant des caractéristiques différentes, ce qui complique leur conception et leur fabrication.

De plus, les détecteurs employés dans ces systèmes optiques présentent parfois un spectre de détection différent du spectre d'émission du laser à semi-conducteur employé comme source de rayonnement. Ceci pose un problème de compatibilité de la source et du détecteur, et pose en outre un problème de sensibilité du détecteur aux rayonnements parasites émis par d'autres sources.

Dans le domaine des barrières opto-électroniques, pour la protection des machines-outils et, en particulier, des presses, les systèmes de l'art antérieur sont ainsi constitués d'une ou plusieurs sources lumineuses et d'un ou plusieurs détecteur associés. La source lumineuse est avantageusement un laser à semi-conducteur dont le faisceau traverse la zone à protéger et est ensuite reçu par le détecteur associé. L'interruption du faisceau par un organe quelconque est perçue par le détecteur et permet de déclencher un dispositif de sécurité. Ainsi, sur les presses, le faisceau du laser se trouve sous la partie mobile de la presse et le dispositif de sécurité empêche la descente de la presse dès que le faisceau est interrompu. Pour permettre le travail, l'interruption du faisceau par la presse elle-même n'est pas prise en compte. Ce type de dispositif présente l'inconvénient de ne pouvoir s'adapter facilement. Un changement par exemple de l'épaisseur du matériau travaillé, ou encore un travail sur une pièce particulièrement volumineuse dont l'introduction dans la machine coupe le faisceau du laser, empêche la presse de fonctionner. L'opérateur doit dans un tel cas modifier la position du faisceau lumineux, ce qui implique un réglage supplémentaire ou désactiver le mécanisme de protection à l'aide d'un contact d'inhibition, ce qui supprime toute protection. Ceci est particulièrement gênant dans le cas des presses, lors du traitement de tôles pliées, par exemple pour constiuer des boîtes.

Pour pallier cet inconvénient, il a été proposé d'utiliser un système constitué d'une pluralité de sources associées chacune à un détecteur, constituant une pluralité de faisceaux couvrant une zone étendue. Dans ce cas, pour des travaux particuliers, il suffit de désactiver certains faisceaux. Cette solution est satisfaisante du point de vue de la protection, mais présente l'inconvénient d'être onéreuse et de nécessiter un appareillage plus complexe.

Dans le domaine de la mesure sans contact ou de la lecture, les systèmes existants sont constitués d'une source lumineuse telle qu'un laser à semi-conducteur, d'un détecteur qui lui est associé et d'une optique de focalisation. On rencontre ici aussi les problèmes d'alignement du détecteur et de sensibilité aux rayonnements parasites.

La présente invention permet de résoudre ces problèmes. Elle permet de simplifier les systèmes existants en supprimant la nécessité d'un détecteur. Elle évite les perturbations dues aux rayonnements parasites. Pour la protection par barrières opto-électroniques, elle simplifie les systèmes et améliore la sécurité des opérateurs.

La présente invention a pour objet un laser à semi-conducteur dans lequel au moins l'une des faces miroir dudit laser a subi un traitement anti-reflet pour permettre la détection d'un rayonnement lumineux de longueur d'onde comprise dans le spectre d'émission dudit laser.

Selon un mode de réalisation de la présente invention, ladite ou lesdites faces miroir ayant subi le traitement anti-reflet présente un coefficient de réflexion inférieur ou égal à $10^{-3}$.

L'invention a également pour objet un procédé d'obtention d'un détecteur photosensible, consistant à traiter une ou plusieurs faces miroir d'un laser à semi-conducteur par un traitement anti-reflet.

Selon un mode de mise en oeuvre du procédé de la présente invention, ledit traitement antireflet consiste à déposer sur ladite ou lesdites faces miroir une couche mince de matériau diélectrique.

Avantageusement, ledit matériau diélectrique est formé d'au moins un des composés appartenant à la liste comprenant $SiO_x$, $Al_2O_3$, $Si_3N_4$.

Ladite couche mince présente de préférence une épaisseur d'environ $\lambda/2n$, $\lambda$ étant la longueur d'onde du rayonnement du laser, et n l'indice de réfraction du matériau diélectrique.

L'invention concerne également l'application d'un laser à semi-conducteur ayant subi un traitement anti-reflet sur au moins l'une de ses faces miroir à la détection d'un rayonnement lumineux de longueur d'onde comprise dans le spectre d'émission dudit laser.

La présente invention s'applique aussi à la réalisation de barrières opto-électroniques, comprenant un ou plusieurs lasers, et des moyens d'évaluation de la tension aux bornes dudit ou desdits lasers.

Selon un autre mode de réalisation, la présente invention s'applique à la réalisation de systèmes de mesure optique sans contact, qui comprennent comme source et comme détecteur de rayonnement un ou plusieurs lasers.

Selon encore un autre mode de réalisation, la présente invention s'applique à la réalisation de systèmes de lecture, comprenant comme source et comme détecteur de rayonnement un ou plusieurs lasers.

Les caractéristiques et avantages de la présente invention ressortiront mieux de la description suivante, donnée à titre d'exemple uniquement, et où:

- la figure 1 est une représentation schématique d'un laser à semi-conducteur;
- la figure 2 est une représentation schématique d'un laser à semi-conducteur agissant selon l'invention comme détecteur de rayonnement;
- la figure 3 est un schéma de principe d'une application d'un laser selon l'invention;
- la figure 4 est un schéma de principe d'une application d'un laser à semi-conducteur à la réalisation d'une barrière opto-électronique;
- la figure 5 est un schéma de principe d'une autre application d'un laser à semi-conducteur à la réalisation d'une barrière opto-électronique;
- la figure 6 est un schéma de principe d'une autre application d'un laser à semi-conducteur à la réalisation d'un système de mesure optique sans contact;
- la figure 7 est un schéma de principe d'une autre application d'un laser à semi-conducteur à la réalisation d'un système de lecture.

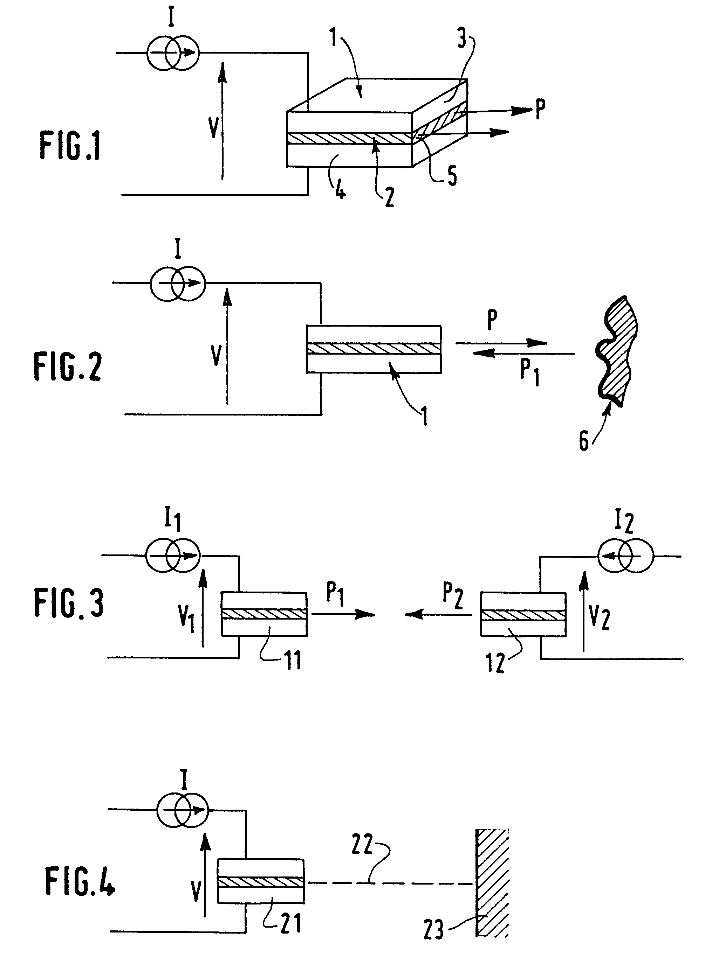

La figure 1 est une représentation schématique d'un laser à semi-conducteur 1. Le laser à semi-conducteur est constitué d'une couche guide d'onde 2 disposée dans une jonction P-N, entre la couche P 3 et la couche N 4. La couche guide d'onde 2 présente deux faces miroir, l'une de ces faces miroir apparaissant sur le schéma de la figure 1 sous la référence numérique 5, l'autre face miroir lui étant opposée. Le laser à semi-conducteur 1 émet un rayonnement sur ses deux faces miroir ou, comme sur le schéma de la figure 1, sur une seule d'entre elle, l'autre face miroir ayant subi un traitement la rendant réfléchissante. Le laser à semi-conducteur 1 est excité par un signal électrique appliqué entre la couche P et la couche N, qui est caractérisé par un courant de polarisation I et par une tension V. Le laser à semi-conducteur 1 émet un rayonnement P par sa face miroir 5 dès lors que le courant de polarisation I dépasse une valeur seuil.

Selon l'invention, on effectue sur la face miroir 5 un traitement anti-reflet et on utilise le laser à semi-conducteur 1 ainsi traité non seulement comme source de rayonnement, mais aussi comme détecteur de rayonnement.

Les faces miroir du laser à semi-conducteur 1 sont obtenues par clivage et constituent chacune pour le rayonnement une surface semi-réfléchissante. La réflectivité d'une face miroir, autrement dit le coefficient de réflexion en puissance d'une face miroir, présente après clivage une valeur qui est typiquement de l'ordre de 0,3. Ce coefficient de réflexion en puissance représente la proportion de la puissance du rayonnement incident qui est réfléchie sur la surface semi-réfléchissante. Le traitement antireflet d'une face miroir a pour effet d'abaisser cette réflectivité à une valeur beaucoup plus faible, qui selon l'invention est de l'ordre de $10^{-4}$. Ce traitement antireflet selon l'invention peut être réalisé de façon connue et on décrit plus loin un mode de réalisation possible.

Selon l'invention, on utilise le laser à semi-conducteur ayant subi sur sa face miroir ce traitement antireflet, non seulement comme émetteur de rayonnement, mais comme détecteur de rayonnement. La figure 2 est une vue schématique d'un laser à semi-conducteur agissant selon l'invention comme détecteur de rayonnement. Le laser à semi-conducteur 1 a subi un traitement rendant l'une de ses faces miroir réfléchissante, et a subi sur l'autre face miroir un traitement antireflet selon l'invention. Par la face miroir ayant subi un traitement antireflet, le laser à semi-conducteur 1 émet un rayonnement de puissance P. Ce rayonnement est réfléchi par un obstacle 6, et un rayonnement de puissance $P_1$ est rétrodiffusé vers la face miroir du laser semi-conducteur 1. Le rayonnement de puissance $P_1$ rétrodiffusé par l'obstacle 6 dans le guide d'onde 2 du laser 1 induit une variation de la tension V aux bornes du laser à semi-conducteur 1, l'intensité I traversant celui-ci étant maintenue à une valeur constante.

Ainsi, la mesure de la valeur de la tension aux bornes du laser à semi-conducteur 1 permet d'évaluer la puissance $P_1$ du rayonnement rétrodiffusé par un obstacle 6 vers la face miroir du laser 1. Le tableau suivant montre la variation de la tension aux bornes du laser 1, en fonction du rapport $P_1/P$, c'est-à-dire en fonction de la proportion de la puissance P rétrodiffusée vers la face miroir. Le tableau montre les valeurs approximatives en millivolts des variations de la tension pour différents traitements antireflet de la face miroir du laser et, en particulier, en l'absence de traitement antireflet, avec R = 0,3. Les valeurs numériques ont été obtenues pour un laser de type FP-BH (structure enterrée à guidage par l'indice de type Fabry-Pérot), émettant à une longueur d'onde de 1,3 μm, alimenté par une source de courant constant d'une intensité deux à trois fois supérieure à son courant de seuil.

| | | $P_1/P$ | | | |
|---|---|---|---|---|---|
| | | O | 1% | 10% | 100% |
| R | 0,3 | O | $2.10^{-2}$ | 2 | 5 |
| | $10^{-2}$ | O | 3 | 10 | 18 |
| | $10^{-4}$ | O | 12 | 25 | 35 |

Grâce à l'invention, il est donc possible de mesurer avec efficacité et précision la proportion de la puissance lumineuse rétrodiffusé vers la face miroir du laser à semi-conducteur 1.

Selon l'invention, au moins une face miroir du laser à semi-conducteur subit un traitement antireflet, de manière à abaisser sa réflectivité. Ce traitement antireflet peut être réalisé de façon quelconque et par une méthode connue. Un mode de réalisation préféré consiste à déposer sur ladite ou lesdites faces miroir une couche mince de matériau diélectrique. Ce matériau diélectrique est formé d'au moins un des composés appartenant à la liste comprenant $SiO_x$, $Al_2O_3$, $Si_3N_4$. La couche mince présente une épaisseur d'environ $\lambda/2n$, $\lambda$ étant la longueur d'onde du rayonnement du laser, et n l'indice de réfraction du matériau diélectrique.

Ce traitement antireflet selon l'invention permet d'abaisser la réflectivité de la face miroir de sorte qu'elle soit inférieure ou égale à $10^{-3}$. Ainsi, la tension peut être facilement mesurée aux bornes du laser à semi-conducteur, même avec un équipement conventionnel.

Dans l'exemple de réalisation de l'invention décrit en référence à la figure 2, le laser à semi-conducteur 1 détecte le rayonnement rétrodiffusé par l'obstacle 6 et la variation de tension aux bornes du laser permet de mesurer la proportion de rayonnement revenant vers la face miroir du laser. Bien entendu, il est possible selon l'invention d'utiliser le laser à semi-conducteur 1 pour détecter un rayonnement lumineux provenant d'une source de nature quelconque et dont la longueur d'onde est comprise dans le spectre d'émission du laser. Par exemple, il est possible d'utiliser comme source lumineuse un laser de même type, dont le faisceau est focalisé sur la face miroir du laser ayant subi un traitement antireflet. Il est aussi possible d'utiliser toute source émettant un rayonnement dans la bande d'émission du laser.

La figure 3 est un schéma de principe d'une application d'un laser selon l'invention. Dans le mode de réalisation de la figure 3, on utilise deux lasers à semi-conducteur 11, 12 qui émettent l'un vers l'autre. De la sorte, chacun des deux lasers à semi-conducteur 11, 12 constitue pour l'autre une source de rayonnement. Bien entendu, un laser à semi-conducteur ne peut selon l'invention que détecter le rayonnement lumineux dans son propre spectre d'émission. On utilise donc de préférence des lasers à semi-conducteur identiques, et présentant un spectre d'émission assez étendu. Par exemple, on peut utiliser des lasers à semi-conducteur à cavité optique longue et ayant subi, sur leurs deux faces miroir, un traitement antireflet. Des lasers de ce type émettent dans des modes longitudinaux rapprochés et présentent un spectre étendu.

Dans l'exemple de la figure 3, chacun des deux lasers 11, 12 est respectivement alimenté par un signal électrique d'intensité $I_1$, $I_2$, présente une tension entre ses bornes $V_1$, $V_2$ et émet l'un vers l'autre laser un rayonnement de puissance $P_1$, $P_2$. L'intensité $I_1$ étant maintenue constante, les variations de la tension $V_1$ aux bornes du laser 11 permettent d'évaluer la puissance $P_2$ émise par le laser 12. Réciproquement, les variations de la tension $V_2$ aux bornes du laser 12 permettent d'évaluer la puissance $P_1$. Les variations des tensions $V_1$ et $V_2$ prennent des valeurs qui sont données à titre d'exemple dans la dernière colonne du tableau ci-dessus, dans le cas où les deux lasers présentent des spectres d'émission identiques et des puissances égales.

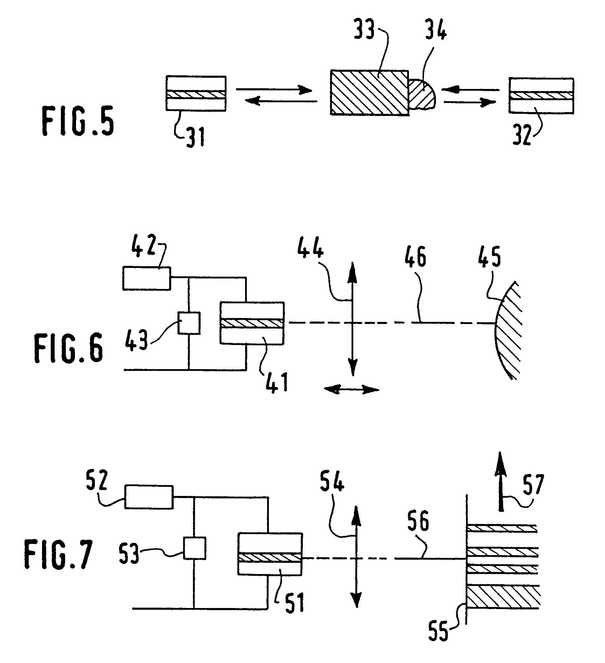

La figure 4 montre un schéma d'une application d'un laser à semi-conducteur ayant subi un traitement sur au moins l'une de ses faces miroir à la réalisation d'une barrière opto-électronique. La barrière opto-électronique de la figure 4 comprend un laser à semi-conducteur 21, agissant comme émetteur d'un faisceau 22, et comme détecteur optique. Le laser 21 est alimenté par un circuit non détaillé qui fournit un signal électrique d'intensité I et de tension V. La barrière opto-électronique comprend en outre un miroir 23 qui réfléchit le faisceau 22 vers le laser 21.

Le dispositif de la figure 4 constitue entre le laser 21 et le miroir 23 une barrière opto-électronique. Lorsque le faisceau 22 atteint le miroir 23 et est réfléchi vers le laser 21, on mesure une certaine valeur de la tension V aux bornes du laser 21. Si un objet s'interpose entre le laser 21 et le miroir 23 sur le trajet du faisceau 22, la proportion de rayonnement réfléchi vers le laser 21 change, et la tension aux bornes du laser 21 varie. La variation de la tension dépend des propriétés de surface de l'objet qui coupe la barrière opto-électronique, ce qui permet le cas échéant d'identifier cet objet. Par exemple, dans le cas d'une machine-outil ou d'une presse, la variation de la tension prend une valeur différente si l'objet est absorbant, comme par exemple la main de l'opérateur, ou si l'objet rétrodiffuse une forte proportion de la puissance lumineuse qu'il reçoit, comme c'est le cas pour une tôle.

La figure 5 montre un schéma de principe d'une autre application d'un laser à semi-conducteur à la réalisation d'une barrière opto-électronique. La barrière optoélectronique de la figure 5 est constituée de deux lasers à semi-conducteur 31, 32 selon l'invention, qui émettent chacun l'un vers l'autre un faisceau formant la barrière optoélectronique. Sur la figure 5, on a représenté le cas où la barrière est coupée par l'introduction d'un objet présentant, d'une part, une surface fortement rétrodiffusante et, d'autre part, une surface faiblement rétrodiffusante. Cet objet peut par exemple être, dans le cas d'une machine-outil, constitué d'une pièce métallique 33 et de la main 34 d'un opérateur. Le faisceau émis par le laser 31 est rétrodiffusé par la pièce métallique 33, tandis que le faisceau émis par le laser 32 est rétrodiffusé par la main 34 de l'opérateur. La mesure des tensions $V_1$, $V_2$ aux bornes des lasers 31, 32 et la comparaison en l'absence d'objet dans la barrière opto-électronique permet de constater qu'un objet a coupé la barrière et permet, en outre, de constater que cet objet présente, du côté du laser 31, une surface fortement rétrodiffusante et, du côté du laser 32, une surface faiblement rétrodiffusante.

Une barrière opto-électronique telle que celle de la figure 4 ou celle de la figure 5 constitue un système de protection simple et efficace pour une machine-outil, qui pallie les inconvénients de l'art antérieur. La barrière opto-électronique selon l'invention permet de différencier la main de l'opérateur d'une pièce destinée à être usinée. De ce fait, il n'est plus nécessaire d'effectuer pour chaque série de travaux un réglage de la hauteur du faisceau, ou un réglage d'un contact d'inhibition.

Le tableau ci-dessous montre les valeurs approximatives en millivolts des variations de tension mesurées aux bornes des lasers à semi-conducteur d'une barrière telle que celle de la figure 5, pour différents objets coupant le faisceau.

| | $\Delta V_1$ | $\Delta V_2$ |
|---|---|---|
| faisceau non interrompu | 30 | 30 |
| tôle | 10 | 10 |
| main de l'opérateur | $10^{-2}$ | $10^{-2}$ |

Les valeurs du tableau ci-dessus sont obtenues pour des lasers de type FP-BH, présentant une réflectivité de miroir de l'ordre de $10^{-4}$, et alimentés par un courant constant d'intensité deux à trois fois supérieure à leur courant de seuil, et formant une barrière opto-électronique d'une longueur d'environ 1 m. Bien entendu, il est possible de réaliser des barrières opto-électroniques selon l'invention d'une longueur bien supérieure à cette valeur de 1 m, utilisée à titre expérimental. La mesure de $\Delta V_1$ et $\Delta V_2$ permet, avec un circuit logique simple, de commander avec sûreté une machine-outil.

Bien entendu, une barrière opto-électronique comme celle de la figure 4 ou de la figure 5 est susceptible d'être utilisée avec profit pour toute autre application que pour la protection d'une machine-outil, et par exemple pour des systèmes d'alarme et autre. Il est possible de prévoir plusieurs lasers à semi-conducteur, constituant des réseaux de faisceaux, pour localiser avec précision des objets, comme cela apparaît bien à l'homme du métier. L'invention permet de simplifier tous les systèmes existant en supprimant la nécessité de récepteurs distincts des émetteurs de rayonnement.

La figure 6 est un schéma de principe d'une application d'un laser à semi-conducteur selon l'invention à la réalisation d'un système de mesure optique sans contact. Le système de la figure 6 comprend un laser à semi-conducteur 41 selon l'invention, un circuit d'alimentation 42 et d'évaluation 43, ainsi qu'une optique de focalisation asservie 44, dont l'axe optique coïncide avec le faisceau émis par le laser. La mesure de la distance séparant le laser d'un objet 45 sur lequel le faisceau 46 du laser est pointé s'effectue en modifiant la position de l'optique de focalisation 44, et en mesurant pour différentes positions de l'optique de focalisation la tension aux bornes du laser. Lorsque la focalisation se fait exactement à la surface de l'objet 45, la proportion de rayonnement réfléchie vers le laser 44 est maximale et la tension aux bornes du laser 41 est minimale. Le système permet ainsi une mesure optique sans contact de la distance entre le laser et l'objet, sans nécessiter de photodétecteur. Bien entendu, le système de la figure 6 peut être utilisé pour d'autres mesures que la mesure de la distance à l'objet 45 et, par exemple, pour la mesure d'états de surface, de vibration, et autres. En fait, le système de la figure 6 est susceptible d'effectuer toute mesure qui, dans les systèmes connus, est réalisée avec un laser colimaté et focalisé, associé à un récepteur de rayonnement.

La figure 7 montre un schéma de principe d'une application d'un laser à semi-conducteur à la réalisation d'un système de lecture. Le système de lecture de la figure 7 comprend un laser à semi-conducteur 51 selon l'invention, un circuit d'alimentation 52 et d'évaluation 53, ainsi qu'une optique de focalisation 54. Le faisceau 56 du laser est colimaté et focalisé sur une surface à lire 55, qui est dans l'exemple de la figure 7 constituée d'un code barre. La flèche 57 symbolise le déplacement relatif de la surface à lire 55 par rapport au faisceau 56 du laser. Les différences des états de surface de la surface 55 à lire induisent des variations du taux de rétrodiffusion du rayonnement vers le laser 51, et ces variations sont détectées par le circuit d'évaluation 53. Un système tel que celui de la figure 7 est avantageusement utilisé pour tout type de lecture laser et, par exemple, pour la lecture de codes barres, de disques numériques, pour la lecture de documents par balayage, etc.

Bien entendu, la présente invention n'est pas limitée aux modes de réalisation décrits et représentés mais elle est susceptible de nombreuses variantes accessibles à l'homme de l'art sans que l'on ne s'écarte de l'esprit de l'invention.

## Revendications

1.- Laser à semi-conducteur (1) de type Fabry-Pérot caractérisé en ce qu'au moins l'une des faces miroir (5) dudit laser a subi un traitement anti-reflet pour permettre, en même temps que l'émission d'un rayonnement par le laser, la détection d'un rayonnement lumineux de longueur d'onde comprise dans le spectre d'émission dudit laser.

2.- Laser à semi-conducteur selon la revendication 1, caractérisé en ce que ladite ou lesdites faces miroir ayant subi le traitement anti-reflet présente un coefficient de réflexion inférieur ou égal à $10^{-3}$.

3.- Laser à semi-conducteur selon la revendication 1 ou 2, caractérisé en ce que ladite ou lesdites faces miroir ayant subi le traitement anti-reflet sont revêtues d'une couche mince de matériau diélectrique, formé d'au moins un des composés appartenant à la liste comprenant $SiO_x$, $Al_2O_3$, $Si_3N_4$.

4.- Procédé pour l'obtention d'un détecteur photosensible agissant simultanément comme émetteur, consistant à traiter une ou plusieurs faces miroir d'un laser à semi-conducteur de type Fabry-Pérot par un traitement anti-reflet.

5.- Procédé selon la revendication 4, caractérisé en ce que ledit traitement antireflet consiste à déposer sur ladite ou lesdites faces miroir une couche mince de matériau diélectrique.

6.- Procédé selon la revendication 5, caractérisé en ce que ledit matériau diélectrique est formé d'au moins un des composés appartenant à la liste comprenant $SiO_x$, $Al_2O_3$, $Si_3N_4$.

7.- Procédé selon la revendication 5 ou 6, caractérisé en ce que ladite couche mince présente une épaisseur d'environ $\lambda/2n$, $\lambda$ étant la longueur d'onde du rayonnement du laser, et n l'indice de réfraction du matériau diélectrique.

8.- Application d'un laser à semi-conducteur de type Fabry-Pérot ayant subi un traitement anti-reflet sur au moins l'une de ses faces miroir à la détection d'un rayonnement lumineux de longueur d'onde comprise dans le spectre d'émission dudit laser, le laser agissant simultanément comme émetteur.

**9.-** Application de lasers à semi-conducteurs selon l'une des revendications 1 à 3, à la réalisation de barrières opto-électroniques, lesdites barrières opto-électroniques comprenant un ou plusieurs desdits lasers, et des moyens d'évaluation de la tension aux bornes dudit ou desdits lasers.

**10.-** Application de lasers à semi-conducteurs selon la revendication 9, caractérisée en ce que lesdits lasers sont polarisés au-dessus de leur courant de seuil.

**11.-** Application de lasers à semi-conducteurs selon l'une des revendications 1 à 3, à la réalisation de systèmes de mesure optique sans contact, lesdits systèmes de mesure optique comprenant comme source et comme détecteur de rayonnement un ou plusieurs desdits lasers, le ou lesdits laser(s) agissant simultanément comme source et comme détecteur de rayonnement.

**12.-** Application de lasers à semi-conducteurs selon l'une des revendications 1 à 3, à la réalisation de systèmes de lecture, lesdits systèmes de lecture comprenant comme source et comme détecteur de rayonnement un ou plusieurs desdits lasers, le ou lesdits laser(s) agissant simultanément comme source et comme détecteur de rayonnement.

FIG.1

FIG.2

FIG.3

FIG.4

FIG.5

FIG.6

FIG.7

Office européen
des brevets

**RAPPORT DE RECHERCHE EUROPEENNE**

Numero de la demande

EP 93 40 1971

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | IEEE JOURNAL OF QUANTUM ELECTRONICS. vol. QE-17, no. 7 , Juillet 1981 , NEW YORK US pages 1216 - 1225 Y. MITSUHASHI ET AL 'Voltage change across the self-coupled semiconductor laser.' | 1,4,5,8 | H01S3/00 H01L31/12 G01S17/02 |
| A | *chapitres I, II* * figure 2 * | 9-12 | |
| Y | EP-A-0 356 302 (ETAT FRANÇAIS) | 1,4,5,8 | |
| A | * abrégé; figure 1 * * colonne 5, ligne 52 - colonne 6, ligne 44; revendications * | 1,3,6 | |
| A | EP-A-0 420 742 (ETAT FRANÇAIS) * abrégé; figure 4 * * colonne 3, ligne 57 - colonne 8, ligne 23 * | 1,4,5,8 | |
| A | JOURNAL OF APPLIED PHYSICS. vol. 56, no. 3 , 1 Août 1984 , NEW YORK US pages 869 - 871 M. JOHNSON ET AL 'Self-detecting light-emitting diode optical sensor.' * le document en entier * | 1,4,8,12 | DOMAINES TECHNIQUES RECHERCHES (Int.Cl.5) H01S H01L G01S |
| A | EP-A-0 245 085 (BRITISH TELECOM.) * le document en entier * | 1,2,4,5, 8 | |
| A | PATENT ABSTRACTS OF JAPAN vol. 12, no. 135 (E-604)23 Avril 1988 & JP-A-62 260 381 (MATSUSHITA ELECTRIC IND.) * abrégé * | 1,3-7 | |
| A | EP-A-0 466 598 (FRANCE TELECOM) * colonne 1 * | 1-7 | |

-/--

Le présent rapport a été établi pour toutes les revendications

| Lieu de la recherche | Date d'achèvement de la recherche | Examinateur |
|---|---|---|
| LA HAYE | 2 Novembre 1993 | CLAESSEN, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

Office européen
des brevets

**RAPPORT DE RECHERCHE EUROPEENNE**

Numero de la demande

EP 93 40 1971

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | PATENT ABSTRACTS OF JAPAN<br>vol. 10, no. 68 (P-437)18 Mars 1986<br>& JP-A-60 207 081 (TOSHIBA KK)<br>* abrégé * | 1,4,8-11 | |
| A | US-A-3 996 476 (LAZZARA)<br>* abrégé; figures 2,3 * | 8-12 | |
| A | FR-A-2 411 421 (LASAG S.A.)<br>* page 2, ligne 3 - ligne 19; figures 1,2 * | 8,11 | |

**DOMAINES TECHNIQUES RECHERCHES (Int.Cl.5)**

Le présent rapport a été établi pour toutes les revendications

| Lieu de la recherche | Date d'achèvement de la recherche | Examinateur |
|---|---|---|
| LA HAYE | 2 Novembre 1993 | CLAESSEN, L |

EPO FORM 1503 03.82 (P04C02)